Europäisches Patentamt

European Patent Office

Office européen des brevets

(11) Veröffentlichungsnummer: **0 339 529**
**A2**

## (12) EUROPÄISCHE PATENTANMELDUNG

(21) Anmeldenummer: **89107306.6**

(22) Anmeldetag: **22.04.89**

(51) Int. Cl.⁴: **H03G 1/00**

(30) Priorität: **26.04.88 DE 3814041**

(43) Veröffentlichungstag der Anmeldung:
**02.11.89 Patentblatt 89/44**

(84) Benannte Vertragsstaaten:
**AT BE CH DE ES FR GB IT LI NL SE**

(71) Anmelder: **Standard Elektrik Lorenz
Aktiengesellschaft
Lorenzstrasse 10
D-7000 Stuttgart 40(DE)**

(84) **DE**

Anmelder: **ALCATEL N.V.
Strawinskylaan 341 (World Trade Center)
NL-1077 XX Amsterdam(NL)**

(84) **BE CH ES FR GB IT LI NL SE AT**

(72) Erfinder: **Benz, Paul
Schwärmerweg 7
D-7000 Stuttgart 1(DE)**
Erfinder: **Lippold, Günther
Muschelkalkweg 16
D-7302 Ostfilern 2(DE)**

(74) Vertreter: **Graf, Georg Hugo, Dipl.-Ing. et al
Standard Elektrik Lorenz AG Patent- und
Lizenzwesen Postfach 30 09 29
D-7000 Stuttgart 30(DE)**

(54) **Steuerbarer Wechselspannungsverstärker.**

(57) Dual-Gate-Transistoren haben eine geringere Grenzfrequenz als Single-Gate-Transistoren.

Der erfindungsgemäße, steuerbare Wechselspannungsverstärker enthält einen Single-Gate-Feldeffekttransistor ($F_1$) in Sourceschaltung. Gateseitig liegt das zu verstärkende, hochfrequente Eingangssignal an. Die Drain-Strom wird durch eine steuerbare Spannung ($U_{St}$) variiert; dadurch ändert sich die Verstärkung, während sich der Lastwiderstand beim Steuervorgang nicht ändert.

Die Steilheit S der Verstärkung der Gate-Feldeffekttransistor, ist proportional zur Wurzel aus dem Drain-Strom.

Daher lassen sich mehrere Single-Gate-Feldeffekttransistoren ($F_1$, $F_2$, $F_3$, $F_4$) zu einem Mehrstufenverstärker in Serie schalten, ohne sich gegenseitig zu stören.

FIG 3

## Steuerbarer Wechselspannungsverstärker

Die Erfindung betrifft einen Wechselspannungsverstärker, insbesondere Breitbandverstärker für die optische Nachrichtentechnik, mit einem Single-Gate-Feldeffekttransistor, an dem gateseitig die zu verstärkende Eingangsspannung anliegt.

Als Wechselspannungsverstärker sind solche bekannt, die einen Dual-Gate-Feldeffekttransistor enthalten, welcher etwa in einem Frequenzbereich von wenigen Hertz bis zu mehreren Gigahertz arbeitet.

Ein Dual-Gate-Feldeffekttransistor läßt sich auffassen als Kaskodeschaltung, dargestellt durch zwei Single-Gate-Transistoren, wobei der Eingangstransistor in Sourceschaltung, der Ausgangstransistor als Gatestufe im Anlaufbereich arbeitet. Ein Dual-Gate-Feldeffekttransistor erreicht wegen seiner komplizierten geometrischen Struktur eine kleinere Grenzfrequenz als ein entsprechender Single-Gate-Feldeffekttransistor, wenn man sich ihn als aus zwei Single-Gate-Feldeffekttransistoren zusammengesetzt vorstellt. Außerdem hat der Dual-Gate-Feldeffekttransistor eine höhere Eingangskapazität als der Single-Gate-Feldeffekttransistor. In einem Dual-Gate-Transistor können beim Steuervorgang kleine Ströme auftreten, die auch in der Gatestufe fließen. Dadurch geht die Grenzfrequenz zurück.

Dieser Wechselspannungsverstärker läßt keine sehr große Bandbreite und keine große Dynamik zu.

Es ist die erste Aufgabe der Erfindung, einen Wechselspannungsverstärker zu schaffen, der steuerbar ist und nicht die Nachteile eines Wechselspannungsverstärkers mit einem Dual-Gate-Feldeffekttransistor hat.

Außerdem ist es die Aufgabe der Erfindung, einen steuerbaren Mehrstufenverstärker zu schaffen.

Die erste Aufgabe wird durch einen Wechselspannungsverstärker der eingangs genannten Art dadurch gelöst, daß an dem Single-Gate-Feldeffekttransistor gateseitig eine erste, aus einer Widerstandkombination erzeugte Spannung und drainseitig eine zweite Spannung anliegen, daß die zweite Spannung der ersten Spannung im Vorzeichen entgegengesetzt ist und daß über die zweite Spannung die Verstärkung des ersten Single-Gate-Feldeffekttransistors Steuerbar ist

Vorteilhaft ist, daß sich für den Single-Gate-Feldeffekttransistor jeder Feldeffekttransistor mit einer hohen Transistorfrequenz einsetzen ·läßt, z.B. ein High Electon Mobility Transistor (HEMT)

Weiterbildungen ergeben sich aus den Unteransprüchen 2 bis 4.

Vorteilhaft ist, daß der an diesem Wechselspannungsverstärker anliegende Lastwiderstand nahezu frequenzunabhängig ist. Während sich die Grenzfrequenz als Funktion der Spannung in einer Kaskodenschaltung, wie sie der Dual-Gate-Feldeffekttransistor darstellt, zweifach ändert, wird gemäß der Erfindung nur ein einziger Transistor höherer Grenzfrequenz gesteuert.

Außerdem wird die Aufgabe nach Anspruch 5 durch einen Mehrstufenverstärker dadurch gelöst, daß er aus mehreren, je eine Einzelstufe bildenden Wechselspannungsverstärkern nach Anspruch 1 aufgebaut ist.

Eine Weiterbildung ergibt sich aus Unteranspruch 6.

Weitere Mehrstufenverstärker ergeben sich aus den Ansprüchen 7 und 8.

Gemäß Anspruch 8 arbeiten die Single-Gate-Feldeffekttransistoren der einzelnen Stufen bei nahezu konstanter Drain-Source-Spannung. Sie werden von als Stromquellen wirkenden Transistoren mit einem veränderbaren Drain-Strom im Abschnürbereich der Drain-Source-Spannung gesteuert; der Drain-Strom ist nur davon abhängig, mit welcher Steuerspannung die Transistoren gesteuert werden.

Die Erfindung wird anhand der Figuren in Beispielen erläutert. Es zeigen:

Fig 1 das Prinzip der Verstärkerschaltung mit einem Single-Gate-Feldeffekttransistor in Sourceschaltung;

Fig 2 ein Ausführungsbeispiel des Verstärkers in einer Einzelstufe, den Single-Gate-Feldeffekttransistor aus Fig. 1 enthaltend, mit einem weiteren Feldeffekttransistor zur Spannungssteuerung;

Fig 3 einen Mehrstufenverstärker mit vier Einzelstufen, deren jede einen Single-Gate-Feldeffekttransistor aus Fig. 2 enthält, und mit dem Feldeffekttransistor zur drainseitigen Steuerung;

Fig 4 einen Mehrstufenverstärker mit vier Einzelstufen, deren jede einen Single-Gate-Feldeffekttransistor aus Fig. 2 enthält, und mit dem Feldeffekttransistor zur sourceseitigen Steuerung und

Fig 5 einen Mehrstufenverstärker mit vier Einzelstufen, deren jede einen Single-Gate-Feldeffekttransistor aus Fig. 2 und einen Bipolartransistor als Stromquelle zur drainseitigen Steuerung enthält.

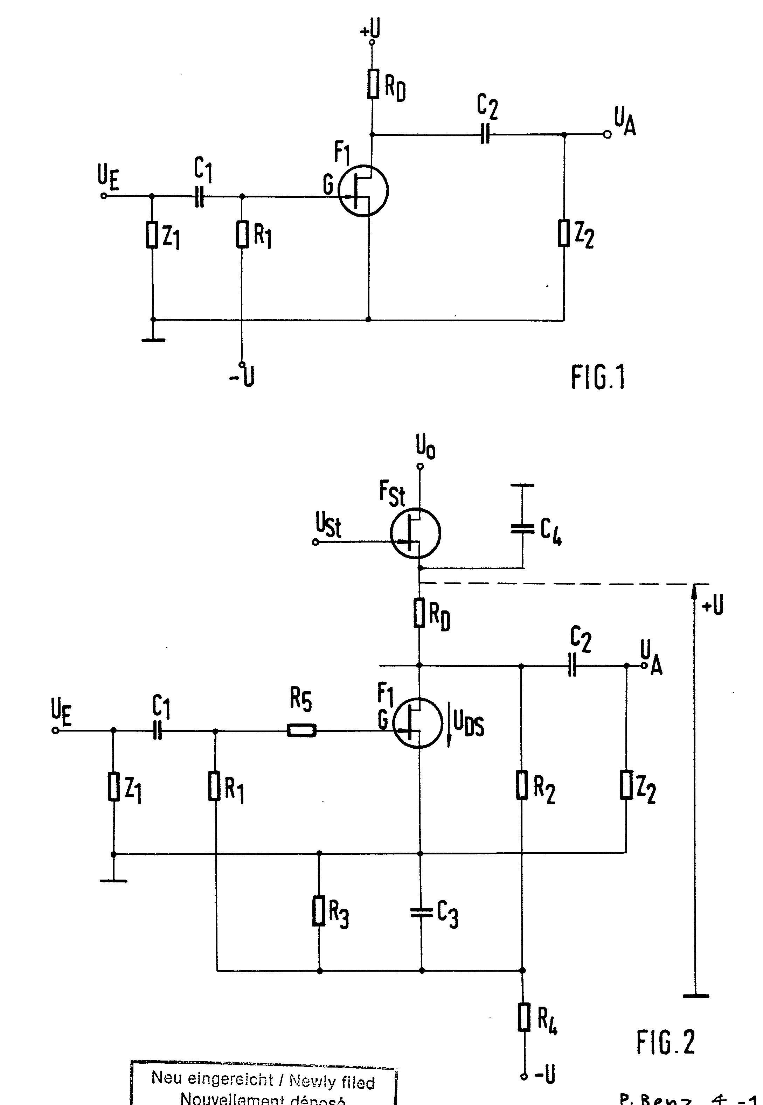

Das in Fig. 1 gezeigte Prinzipschaltbild enthält einen Single-Gate-Feldeffekttransistor $F_1$ in Sourceschaltung. Gleichzeitig liegen an ihm gateseitig über einen Kondensator $C_1$ eine hochfrequente Wechselspannung $U_E$ und über einen Widerstand $R_1$ eine negative, konstante Spannung -U an. Ein Widerstand $Z_1$ stellt den Eingangswiderstand der Schaltung dar. Er wird über den Kondensator $C_1$ an das Gate des Transistors $F_1$ angekoppelt. Ein Widerstand $Z_2$ bildet einen Ausgangslastwiderstand und ist über einen Kondensator $C_2$ mit dem Drainanschluß des Transistors $F_1$ verbunden. Drainseitig, über einen zur Entkopplung dienenden Widerstand $R_D$, liegt ferner eine positive, veränderliche Spannung $+U$ an. Der ohmsche Widerstand $R_D$ kann bei höheren Frequenzen durch eine Breitbandspule ersetzt werden; er dient zudem zur Verstärkungseinstellung.

Daß die Spannungen $+U$, $-U$ positiv bzw. negativ sind, gilt nur im Fall eines n-Kanal-Single-Gate-Feldeffekttransistors $F_1$; bei einem p-Kanal-Transistor müssen sie umgekehrte Polaritäten haben.

Die ausgangsseitige Spannung $U_A$ enthält wegen des Kondensators $C_2$ ebenfalls keinen Gleichstromanteil.

Fig. 2 zeigt eine Einzelstufe des Verstärkers, die neben den Widerständen $R_1$, $R_D$, $Z_1$, $Z_2$ sowie den Kondensatoren $C_1$, $C_2$ noch einen Kondensator $C_3$ und weitere Widerstände $R_2$, $R_3$, $R_4$ enthält, mit denen die Stufe spannungsstabilisiert wird. Auf diese Weise wird ein Teil der Drain-Source-Spannung $U_{DS}$ zusammen mit der Spannung $-U$, die hier eine Betriebsspannung $-U$ ist, gateseitig in den Single-Gate-Feldeffekttransistor eingespeist und eine optimale Gatespannung an ihm eingestellt. Ein Kondensator $C_4$ zwischen dem Widerstand $R_D$ und dem Soureeanschluß eines weiteren Feldeffekttransistors $F_{ST}$ ist mit dem Bezugspotential verbunden, so daß an dem Sourceanschluß nur eine Gleichspannung an liegt.

Die positive Spannung $+U$ wird in diesem Fall von dem Feldeffekttransistor $F_{St}$ leistungslos gesteuert, dessen Drainanschluß mit einer konstanten Spannung $U_o$ verbunden ist, während er gateseitig durch eine Steuerspannung $U_{St}$ gesteuert wird.

In diesem Fall wirkt der Feldeffekttransistor $F_{St}$ als Spannungsquelle. Wenn die Spannung $U_o$ nicht drain-, sondern sourceseitig angeschlossen ist, wirkt er als Stromquelle. Außer einem Transistor $F_{St}$ sind beliebige andere Spannungs- und Stromquellen denkbar, die die Steuerung der Spannung $+U$ gestatten. Diese Spannung $U_{St}$ kann etwa in einem Regelkreis erzeugt werden, in welchem ein Vergleich zwischen Soll- und Ist-Wert der Ausgangsspannung $U_A$ erfolgt.

Ein Ändern der Spannung $+U$ mittels des Feldeffekttransistors $F_{St}$ bewirkt, daß der Drain-Strom am Single-Gate-Feldeffekttransistor $F_1$ ebenfalls variiert wird. Dieser arbeitet dann in einem Bereich variabler Steilheit

$$S = \left( \frac{\partial I_D}{\partial U_{DS}} \right)_{U_{GS}}$$

und veränderbarer Verstärkung.

Anstelle der Spannungssteuerung durch den Feldeffekttransistor $F_{ST}$ läßt sich mit einer Stromquelle auch der Strom steuern.

Ein Widerstand $R_5$ unterdrückt hochfrequente Schwingungen.

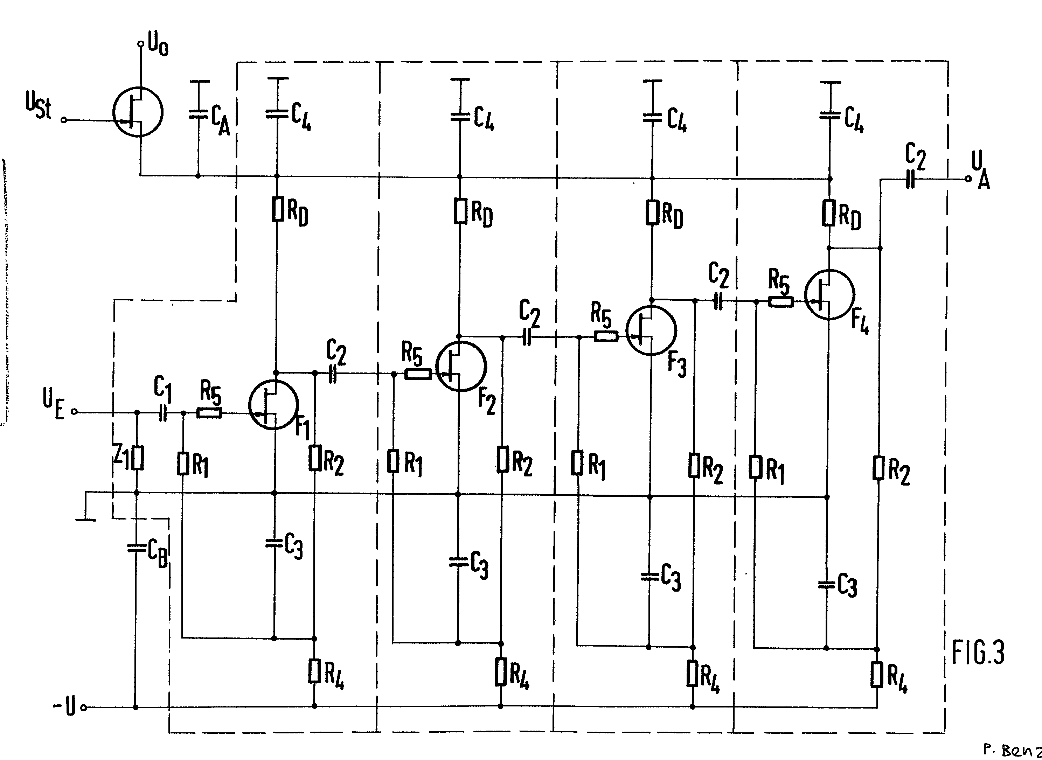

Ein Mehrstufenverstärker (Fig. 3) besteht aus vier Stufen, deren jede einen Single-Gate-Feldeffekttransistor $F_1$, $F_2$, $F_3$, $F_4$ enthält, der jeweils über einen drainseitigen Widerstand $R_D$ mit dem Sourceanschluß des Feldeffekttransistors $F_{St}$ verbunden ist, so daß an allen Single-Gate-Feldeffekttransistoren $F_1$ bis $F_4$ eine gemeinsame, veränderliche positive Spannung $+U$ anliegt. Auf diese Weise wird die Dynamik jedes einzelnen Single-Gate-Feldeffekttransistors $F_1$ bis $F_4$ voll ausgeschöpft.

Bis auf den Widerstand $Z_1$ vor der ersten Stufe entfallen die Widerstände $R_3$, $Z_1$, $Z_2$. Der drainseitige Kondensator $C_2$ jeder Stufe fällt mit dem gateseitigen Kondensator $C_1$ der jeweils nachfolgenden Stufe zusammen.

Zwei Kondensatoren $C_A$, $C_B$, sowie je Stufe zwei Kondensatoren $C_4$, $C_3$ legen die Wechselspannung auf das Bezugspotential.

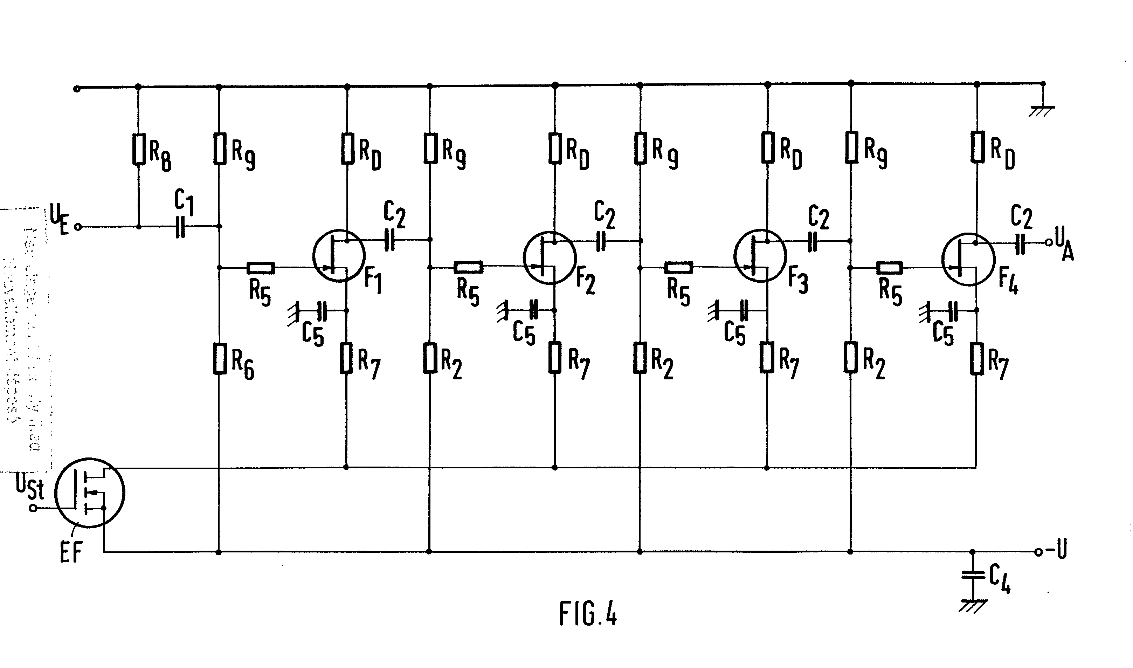

Die Single-Gate-Feldeffekttransistoren $F_1$, $F_2$, $F_3$, $F_4$ eines weiteren, ebenfalls vierstufigen Mehrstufenverstärkers (Fig. 4) werden sourceseitig durch den über einen Widerstand $R_7$ fließenden Drainstrom eines n-Kanal-MOSFET-Anreicherungs-Feldeffekttransistors gesteuert. Dieser selbst wird durch eine Steuerspannung $U_{St}$ gesteuert. Je ein Kondensator $C_5$ dient an der Sourceseite der Single-Gate-Feldeffekttransistoren $F_1$ bis $F_4$ zur Wechselspannungsentkopplung. Eine Betriebsspannungsquelle liefert die eine negative, konstante Betriebsspannung $-U$, die zu den Gateanschlüssen der Feldeffekttransistoren $F_1$ bis $F_4$ jeweils über einen Widerstand $R_6$ und den Widerstand $R_5$ abfällt. Die drainseitigen Widerstände $R_D$ sind jeweils zu Widerständen $R_9$ parallel geschaltet und mit dem Bezugspotential verbunden.

Mit Hilfe der Betriebsspannung $-U$ und der durch die Widerstände $R_2$, $R_9$ gebildeten Spannungsteilers wird die negative, konstante Gate-Spannung erzeugt. Ein Widerstand $R_8$ bildet den Eingangswiderstand der Verstärkerschaltung.

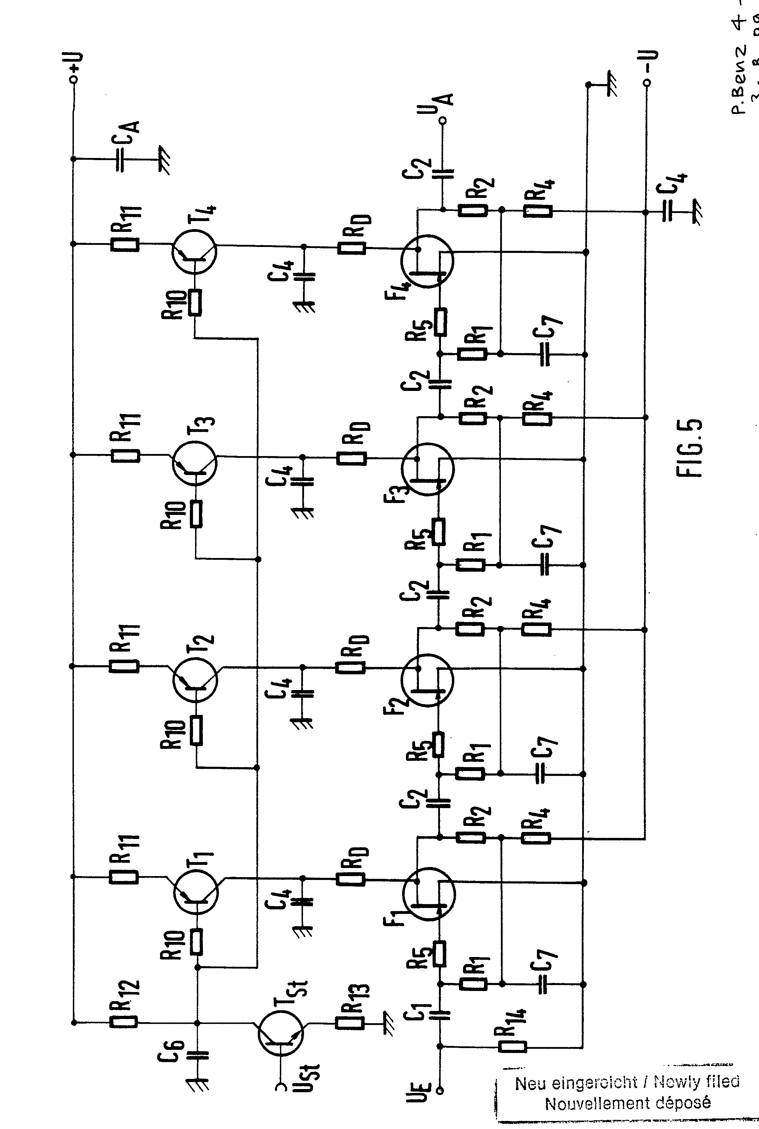

Ein dritter, vierstufiger Mehrstufenverstärker (Fig. 5) enthält als pnp-Bipolartransistoren ausgebildete Transistoren $T_1$ bis $T_4$ in Basisschaltung, deren jeder jeweils einen Single-Gate-Feldeffekttransistor $F_1$ bis $F_4$ über den jeweiligen Widerstand $R_D$

drainseitig steuert. Basisseitig sind den Transistoren $T_1$ bis $T_4$ Widerstände $R_{10}$ vorgeschaltet; über einen Kondensator $C_6$ sind sie mit dem Bezugspotential verbunden. Ihre Basisspannung wird von einem Steuer-Transistor $T_{St}$ kollektorseitig geliefert, der wiederum von einer Steuerspannung $U_{St}$ basisseitig gesteuert wird und dessen Emitter über einen Widerstand $R_{13}$ mit dem Bezugspotential verbunden ist.

An den Transistoren $T_1$ bis $T_4$ liegt emitterseitig über je einem Widerstand $R_{11}$ die konstante Spannung $+U$ an, die ebenso über einen Widerstand $R_{12}$ an dem Kollektor des Steuer-Transistors $T_{St}$ anliegt. Über die Widerstände $R_1$, $R_2$, $R_4$ wird die Gate-Spannung erzeugt. Der Kondensator $C_4$ legt die konstante, negative Spannung -U wechselspannungsmäßig auf das Bezugspotential.

Gateseitig sind die Feldeffekttransistoren $F_1$ bis $F_4$ über die Widerstände $R_1$, $R_5$ sowie über je einen Kondensator $C_7$ mit dem Bezugspotential verbunden.

Über den Kondensator $C_1$ wird die Wechselspannung $U_E$ in den Mehrstufenverstärker eingekoppelt.

Ein Widerstand $R_{14}$ stellt den Eingangswiderstand des Mehrstufenverstärkers dar.

In dieser Schaltung wird die Drain-Source-Spannung $U_{DS}$ der Single-Gate-Feldeffekttransistoren $F_1$ bis $F_4$ so eingestellt, daß sie im Abschnürbereich liegt; dann läßt sich fast völlig unabhängig von der Drain-Source-Spannung $U_{DS}$ der Drainstrom den Transistoren $T_1$ bis $T_4$ einprägen. An Stelle der Transistoren $T_1$ bis $T_4$ lassen sich auch Feldeffekttransistoren oder Darlington-Schaltungen in der Netzwerk einfügen.

In den hier dargestellten vierstufigen Mehrstufenverstärkern ist eine Dynamik in der Verstärkung von bis zu 40 dB im GHz-Bereich möglich. Da jede Stufe einzeln gesteuert wird, ist das Übersteuerungsverhalten günstig.

**Ansprüche**

1. Wechselspannungsverstärker, insbesondere Breitbandverstärker für die optische Nachrichtentechnik, mit einem Single-Gate-Feldeffekttransistor, dessen Drain-Source-Spannung veränderbar ist und an dem gateseitig die zu verstärkende Eingangsspannung anliegt,
**dadurch gekennzeichnet,**
daß an dem Single-Gate-Feldeffekttransistor ($F_1$) gateseitig eine erste, aus einer Widerstandskombination ($R_1$, $C_1$) erzeugte Spannung (-U) und drainseitig eine zweite Spannung ($+U$) anliegen, daß die zweite Spannung ($+U$) der ersten Spannung (-U) im Vorzeichen entgegengesetzt ist und daß über die zweite Betriebsspannung ($+U$) die Verstärkung des Single-Gate-Feldeffekttransistors ($F_1$) steuerbar ist.

2. Wechselspannungsverstärker nach Anspruch 1,
dadurch gekennzeichnet,
daß gateseitig an dem Single-Gate-Feldeffekttransistor ($F_1$) eine Wechselspannung ($U_E$) anliegt, die über eine Kombination von mehreren Widerständen ($R_1$, $R_2$, $R_3$, $R_4$) aus der ersten Spannung (-U) und der Drain-Source-Spannung ($U_{DS}$) gebildet wird.

3. Wechselspannungsverstärker nach Anspruch 1,
dadurch gekennzeichnet,
daß ein weiterer Transistor, insbesondere ein zweiter Single-Gate-Feldeffekttransistor ($F_{St}$), vorhanden ist, der die zweite Spannung ($+U$) erzeugt, dessen Gate leistungslos durch eine Steuerspannung ($U_{St}$) gesteuert wird und an dessen Drainanschluß eine konstante Spannung ($U_o$) anliegt.

4. Wechselspannungsverstärker nach Anspruch 1,
dadurch gekennzeichnet, daß ein weiterer Transistor, insbesondere ein zweiter Feldeffekttransistor ($F_{St}$), vorhanden ist, der die zweite Spannung ($+U$) erzeugt, dessen Gate leistungslos durch eine Steuerspannung ($U_{St}$) gesteuert wird und an dessen Sourceanschluß eine konstante Spannung ($U_o$) anliegt.

5. Mehrstufenverstärker,
dadruch gekennzeichnet,
daß er aus mehreren, je eine Einzelstufe bildenden Wechselspannungsverstärkern nach Anspruch 1 aufgebaut ist.

6. Mehrstufenverstärker nach Anspruch 5,
dadurch gekennzeichnet,
daß die zweite Spannung ($+U$) an allen Single-Gate-Feldeffekttransistoren ($F_1$, $F_2$, $F_3$, $F_4$) gemeinsam anliegt.

7. Mehrstufenverstärker bestehend aus mehreren, je eine Einzelstufe nach dem Oberbegriff des Anspruchs 1 bildenden Wechselspannungsverstärkern,
dadurch gekennzeichnet,
daß an den Single-Gate-Feldeffekttransistoren ($F_1$, $F_2$, $F_3$, $F_4$) gateseitig die erste, Spannung (-U) anliegt, daß die Single-Gate-Feldeffekttransistoren ($F_1$, $F_2$, $F_3$, $F_4$) drainseitig über je einen Widerstand ($R_D$) mit dem Bezugspotential verbunden sind und daß sie sourceseitig über den Drainstrom eines steuerbaren Leistungs-Feldeffekttransistors ($F_{St}$) steuerbar sind.

8. Mehrstufenverstärker bestehend aus mehreren, je eine Einzelstufe nach dem Oberbegriff des Anspruchs 1 bildenden Wechselspannungsverstärkern,
dadurch gekennzeichnet,

daß an den Single-Gate-Feldeffekttransistoren ($F_1$, $F_2$, $F_3$, $F_4$) drainseitig die erste, Spannung (-U) und die zweite, Spannung (+U) über je einen Transistor ($T_1$, $T_2$, $T_3$, $T_4$) und je einen Widerstand ($R_D$) veränderlich anliegen und daß die Drain-Source-Spannung ($U_{DS}$) der Single-Gate-Feldeffekttransistoren ($F_1$, $F_2$, $F_3$, $F_4$) über Widerstände ($R_1$, $R_2$, $R_4$) mittels der ersten Spannung (-U) einstellbar ist.

FIG.1

FIG.2

Neu eingereicht / Newly filed
Nouvellement déposé

P. Benz 4 -1
24. 5. 88
Geändert: 6. 3. 8'

FIG.3

FIG.4

EP 0 339 529 A2

P. Benz 4-1
3 . 8 . 89

FIG.5

EP 0 339 529 A2

Neu eingericht / Newly filed
Nouvellement déposé

P.Benz 4-1
3·8·89